# EUROPÄISCHE PATENTSCHRIFT

(11) **EP 2 164 309 B1**
(45) Veröffentlichungstag und Bekanntmachung des Hinweises auf die Patenterteilung: **22.07.2015**
(21) Anmeldenummer: 09010366.4
(22) Anmeldetag: 12.08.2009
(51) Int. Cl.: H05H 1/46

(54) **Verfahren und Vorrichtung zum Betreiben einer Hohlkathoden-Bogenentladung**
Method and device for operating a hollow cathode arc discharge
Procédé et dispositif pour commander une décharge à cathode creuse

(30) Priorität: 15.09.2008 DE 102008047198
(43) Veröffentlichungstag der Anmeldung: 17.03.2010
(73) Patentinhaber: Fraunhofer-Gesellschaft zur Förderung der angewandten Forschung e.V., 80686 München (DE)
(72) Erfinder: Fietzke, Fred, 01728 Hänichen (DE); Labitzke, Rainer, 01189 Dresden (DE); Krätzschmar, Bernd-Georg, 01187 Dresden (DE)
(74) Vertreter: Ostermann, Dirk

(56) Entgegenhaltungen:
- WO-A-2005/083241
- DE-A1-102006 027 853
- US-A- 3 831 052
- US-A- 5 810 982
- US-A1- 2008 193 782

## Beschreibung

Die Erfindung betrifft ein Verfahren und eine Vorrichtung zum Betreiben einer Hohlkathoden-Bogenentladung innerhalb einer Vakuumkammer.

Aus dem Stand der Technik sind eine Vielzahl von Verfahren und Vorrichtungen zum Betreiben von Hohlkathodenbogenentladungen bekannt, wobei für das Zünden und das Aufrechterhalten der Bogenentladung generell zwei verschiedene Einrichtungen benötigt werden.

Während für das Aufrechterhalten einer Hohlkathoden-Bogenentladung innerhalb einer Vakuumkammer in der einfachsten Ausführung eine von einem Arbeitsgas durchströmte Hohlkathode und eine zwischen Hohlkathode und einer zugehörigen Anode geschaltete Stromversorgungseinrichtung als Spannungsquelle benötigt wird, erfordert das Zünden einer Hohlkathoden-Bogenentladung im Stand der Technik weitere Einrichtungselemente. Üblicherweise erfolgt das Zünden einer Hohlkathoden-Bogenentladung, indem die vom Arbeitsgas durchströmte Hohlkathode mittels zusätzlicher Einrichtungen erhitzt wird. Bei vielen Anwendungen wird eine Hohlkathode mittels einer um die Hohlkathode gewickelten und von einem elektrischen Strom durchflossenen Heizwendel aufgeheizt
(DE 91 13 374 U1). Dabei wird die Heizwendel von einer Stromversorgungseinrichtung gespeist, die nicht identisch ist mit der zwischen Kathode und Anode geschalteten Stromversorgungseinrichtung, welche zum Aufrechterhalten der Bogenentladung benötigt wird. Während des Aufrechterhaltens einer stabil brennenden Bogenentladung wird dann meist durch die Bogenentladung selbst genügend Wärme erzeugt, so dass der Stromfluss durch die Heizwendel reduziert oder vollständig abgeschaltet werden kann.

Gewöhnlich dauert das Zünden einer Hohlkathoden-Bogenentladung mittels einer Heizwendel bis hin zu einer stabil brennenden Bogenentladung mehrere Minuten und kann sich gegebenenfalls bis in den Stundenbereich erstrecken. Ein solches Zündverfahren mittels einer Heizwendel ist außerdem recht unzuverlässig und erfordert aufgrund schnell verschleißender Heizwendeln einen zusätzlichen Wartungs- bzw. Reparaturaufwand. Nachteilig wirkt sich bei diesen Verfahren ebenfalls aus, dass eine separate Stromversorgung für das Bereitstellen des Heizstromes und gegebenenfalls noch eine Steuereinrichtung für das Regeln des Heizstromes benötigt werden.

Aus DE 10 2006 027 853 A1 ist eine Hohlkathoden-Bogenentladungsquelle bekannt, welche unter anderem auch eine Heizwendel zum Zünden der Bogenentladung umfasst. Mittels dieser Hohlkathoden-Bogenentladungsquelle kann eine besondere Art eines sehr intensiven Plasmas erzeugt werden, indem die Flussmenge eines Arbeitsgases durch die Hohlkathode kontinuierlich reduziert wird. Das Reduzieren des Gasflusses durch die Hohlkathode führt jedoch irgendwann zu einem Druckbereich des Arbeitsgases innerhalb des Kathodenrohres, in dem kein stabiler Betrieb der Bogenentladung mehr möglich ist.

In DE 10 2006 027 853 A1 werden keine Maßnahmen angegeben, mit denen ein dauerhaftes Verlöschen der Bogenentladung bei einem solch geringen Arbeitsgasdruck innerhalb des Hohlkathodenrohres verhindert werden kann.

DD 278 221 A1 beschreibt eine Vorrichtung zum Zünden einer Hohlkathoden-Bogenentladung, bei der nach dem Erhitzen der Hohlkathode mittels einer Heizwendel ein Magnetfeld zugeschaltet wird. Auch bei dieser Lösung ist das minutenlange Erhitzen der Hohlkathode erforderlich, bis die Bogenentladung gezündet ist.

Des Weiteren werden Vorrichtungen zum Zünden einer Bogenentladung vorgeschlagen, die verschiedene Hilfselektroden umfassen und auch in Verbindung mit einer Heizwendel zur Anwendung kommen können (US 4 339 691 A, DE 10 2004 010 261 A1).

DE 41 27 317 A1 gibt an ein Plasma zu erzeugen, indem eine Gleichspannungsquelle impulsweise zwischen eine Anode und eine Kathode geschaltet wird. Das Pulsen einer Spannungsquelle wird auch in DE 199 02 146 A1 aufgegriffen. Hier wird eine Hohlkathoden-Bogenentladung mittels einer Gleichspannungsquelle zwischen einer Hohlkathode und einer Anode gezündet, wobei gleichzeitig ein separater Pulsgenerator eine mittel-frequent gepulste Spannung erzeugt, die zwischen die Hohlkathode und eine dritte Elektrode geschaltet wird. Nachteilig wirkt sich bei dieser Konfiguration aus, dass zwei separate Stromversorgungseinrichtungen bereitgestellt werden müssen.

Das Zünden eines Lichtbogenverdampfers ist in DE 100 42 629 A1 beschrieben. Hierfür wird eine lonenquelle verwendet, die zwischen einer Kathode und einer zugehörigen Anode angeordnet wird.

Aus US 5 252 954 A ist schließlich bekannt, eine Hohlkathoden-Bogenentladung mittels ionisierender bzw. radioaktiver Strahlung zu zünden und aufrechtzuerhalten. Derartige Vorrichtungen erfordern jedoch aufwändige Maßnahmen, die den Menschen vor radioaktiver Strahlung schützen.

### Aufgabenstellung

Der Erfindung liegt daher das technische Problem zugrunde ein Verfahren und eine Vorrichtung zu schaffen, mittels derer die Nachteile aus dem Stand der Technik überwunden werden. Insbesondere sollen es Verfahren und Vorrichtung ermöglichen, eine Hohlkathoden-Bogenentladung zu zünden und auch bei einem geringen Arbeitsgasdruck innerhalb des Hohlkathodenrohres stabil aufrechtzuerhalten. Des Weiteren soll mittels erfindungsgemäßen Verfahren und Vorrichtungen eine Hohlkathoden-Bogenentladung in einer gegenüber dem Stand der Technik stark verkürzten Dauer stabil zum Brennen gebracht werden. Dabei soll der Einsatz einer Heizwendel zum Erhitzen der Hohlkathode nicht erforderlich sein.

Die Lösung des technischen Problems ergibt sich durch die Gegenstände mit den Merkmalen der Patentansprüche 1 und 9. Weitere vorteilhafte Ausgestaltungen der Erfindung ergeben sich aus den abhängigen Patentansprüchen.

Erfindungsgemäße Vorrichtungen und Verfahren zum Betreiben einer Bogenentladung zwischen einer Anode und einer rohrförmigen Kathode, durch die ein Arbeitsgas in eine Vakuumkammer geleitet wird, zeichnen sich dadurch aus, dass zumindest ausgangsseitig um die Kathode ein Magnetfeld erzeugt wird, welches Feldlinienbereiche aufweist, die parallel zur Rohrachse oder zumindest weitgehend parallel zur Rohrachse der Kathode verlaufen und dass eine Stromversorgungseinrichtung eine elektrische Spannung zwischen Kathode und Anode erzeugt, wobei mittels der Stromversorgungseinrichtung einerseits die Brennspannung für die Bogenentladung und andererseits mindestens ein Spannungspuls von mindestens 500 V zum Zünden oder Aufrechterhalten der Bogenentladung erzeugbar sind. Mit erfindungsgemäßen Verfahren und Vorrichtungen können Hohlkathoden-Bogenentladungen daher sowohl gezündet als auch stabil brennend aufrechterhalten werden.

Mit jedem Spannungspuls, der während eines Zündvorgangs zwischen der rohrförmigen Kathode (auch Hohlkathode genannt) und der Anode mittels der Stromversorgungseinrichtung erzeugt wird, werden Elektronen aus der Hohlkathode emittiert. Das Magnetfeld mit Feldlinienbereichen parallel zur Rohrachse der Kathode sorgt dafür, dass die emittierten Elektronen während ihrer Flugbewegung auf solchen Bahnen gehalten werden, auf denen sie mit möglichst vielen Arbeitsgaspartikeln, die aus der Hohlkathode in die Vakuumkammer strömen, zusammenstoßen, wodurch diese Arbeitsgaspartikel ionisiert werden können. Die dadurch erzeugten positiv geladenen Ionen erfahren eine Beschleunigung in Richtung Kathode und geben beim Auftreffen auf die Kathode Energie an die Kathode ab, welche in Wärme umgewandelt wird. Je wärmer die Kathode ist, umso leichter lassen sich aus dieser Elektronen emittieren. Andererseits werden beim Auftreffen der Ionen auf die Kathode auch Elektronen emittiert, welche wiederum Arbeitsgaspartikel ionisieren können. So verstärkt sich der Prozess des Emittierens von Elektronen, des lonisierens von Arbeitsgaspartikeln und des Erwärmens der Hohlkathode, der mit jedem Spannungspuls eine weitere Beschleunigung erfährt, bis die Hohlkathoden-Bogenentladung gezündet ist. Mit erfindungsgemäßen Verfahren und Vorrichtungen werden für das Zünden einer Hohlkathoden-Bogenentladung nur einige Millisekunden benötigt und es dauert auch maximal nur wenige Sekunden, bis die Hohlkathoden-Bogenentladung stabil brennt. Die Anzahl der für einen Zündvorgang erforderlichen Spannungspulse ist von einer jeweiligen Anlagenkonfiguration abhängig. Bei Laborversuchen konnte schon nach ein bis drei Spannungspulsen ein Zünden verzeichnet werden.

Für ein sicheres Zünden einer Hohlkathoden-Bogenentladung nach dem erfindungsgemäßen Verfahren zeichnen im Wesentlichen die drei Parameter Magnetfeldstärke, Arbeitsgasdruck im Kathodenrohr (bzw. Flussmenge des Arbeitsgases durch das Kathodenrohr) und Höhe der Spannungspulse verantwortlich, wobei das Zünden vorteilhafter von statten geht, je höher einer oder mehrere dieser Parameter eingestellt sind. Dabei ist es in wirtschaftlicher Hinsicht nicht zweckmäßig und aus funktioneller Sicht auch gar nicht erforderlich, Magnetfeldstärke, Arbeitsgasdruck und Pulsspannung über die Maßen hoch einzustellen.

So ist beispielsweise eine Magnetfeldstärke von 1 kA/m ausreichend für erfindungsgemäße Verfahren und Vorrichtungen. Bevorzugt wird die Magnetfeldstärke in einem Bereich von 5 bis 30 kA/m eingestellt. Magnetfeldstärken in diesem Bereich sind einerseits mit relativ niedrigem technischem Aufwand erzielbar, andererseits sind in diesem Magnetfeldstärken-bereich die Anforderungen hinsichtlich der anderen beiden Parameter Arbeitsgasdruck und Pulsspannung nicht so hoch wie bei Magnetfeldstärken unter 5 kA/m. Um es noch einmal mit anderen Worten auszudrücken: Je höher einer der drei Parameter Magnetfeldstärke, Arbeitsgasdruck im Kathodenrohr und Pulsspannung eingestellt ist, umso geringer sind die Anforderungen hinsichtlich der erforderlichen Höhe der anderen beiden Parameter.

Gänzlich ohne Magnetfeld konnte eine Hohlkathoden-Bogenentladung hingegen nicht gezündet werden, auch wenn der Arbeitsgasdruck im Kathodenrohr und die Pulsspannung relativ hoch eingestellt waren. Für das Erzeugen eines Magnetfeldes mit Feldlinienbereichen, die parallel oder zumindest weitgehend parallel zur Kathodenrohrachse ausgebildet sind, kann beispielsweise eine stromdurchflossene Spule oder eine Anordnung von Permanentmagneten verwendet werden. Bei Laborversuchen ist beispielsweise eine stromdurchflossene Spule von Vorteil, weil mit dieser flexibler unterschiedliche Magnetfeldstärken einstellbar sind. Ist einmal eine vorteilhafte Magnetfeldstärke gefunden, kann das entsprechende Magnetfeld beim industriellen Einsatz auch mit einer Anordnung von Permanentmagneten nachgebildet werden, dann ist beispielsweise auch keine Stromversorgungseinrichtung wie beim Betrieb einer Magnetspule mehr erforderlich.

Bei einer Ausführungsform ist die magnetfelderzeugende Einrichtung als ringförmige Spule ausgebildet, die konzentrisch um die Kathodenrohrachse angeordnet ist. Alternativ kann die ringförmige Spule auch nichtkonzentrisch um die Kathodenrohrachse angeordnet sein, dabei hat die Ausrichtung von Kathodenrohrachse und magnetfelderzeugender Einrichtung jedoch einen Einfluss auf die Ausrichtung und die Form der erzeugten Plasmawolke.

Üblicherweise werden herkömmliche Hohlkathoden-Bogenentladungen mit einer Brennspannung von etwa 10 V bis 50 V betrieben. In jüngerer Vergangenheit sind aus dem Stand der Technik Verfahren und Vorrichtungen zum Betreiben von Hohlkathoden-Bogenentladungen bekannt, bei denen bei einer bestimmten Magnetfeld- und Anodenkonfiguration der Arbeitsgasdruck im Kathodenrohr so weit reduziert wird, bis die Bogenentladung fast erlischt. Bei derartigen Verfahren und Vorrichtungen, die auch unter dem Kürzel HAD⁺ (oder auch HAD plus) bekannt sind und mit denen sich Plasmen mit einer sehr hohen Ladungsträgerdichte erzeugen lassen, werden auch Brennspannungen um 100 V realisiert. Zum Betreiben einer Hohlkathoden-Bogenentladung wird in beiden Fällen eine Stromversorgungseinrichtung benötigt, die eine Gleichspannung, nämlich die Brennspannung, bereitstellt.

Eine Stromversorgungseinrichtung für eine erfindungsgemäße Einrichtung zeichnet sich dadurch aus, dass diese sowohl die Brennspannung als auch Spannungspulse von mindestens 500 V bereitstellt. Die Spannungspulse weisen somit eine Spannungshöhe auf, die um ein Vielfaches höher ist als die Brennspannung. Aus wirtschaftlichen Gründen ist es nicht zweckmäßig, Spannungspulse größer als etwa 2500 V zu erzeugen, weil dann beispielsweise ein zusätzlicher Aufwand hinsichtlich der elektrischen Durchschlagfestigkeit bei den verwendeten Bauelementen betrieben werden muss.

Bei einer Ausführungsform umfasst die Stromversorgungseinrichtung ein Bauteil, mit welchem eine maximale Konstantspannung von mindestens 500 V bereit gestellt wird, und ein Spannungsregelbauteil, mit welchem einerseits die Brennspannung für eine Hohlkathoden-Bogenentladung und andererseits Spannungspulse von mindestens 500 V erzeugt werden können. Für erfindungsgemäße Verfahren und Vorrichtungen sind Spannungspulse mit einer Dauer von 0,5 µs bis 50 µs besonders geeignet, die mit einer Wiederholfrequenz von 10 Hz bis 10 kHz erzeugt werden können. Die von der Stromversorgungseinrichtung zwischen Hohlkathode und Anode bereitgestellte Brennspannung kann entweder als konstante Gleichspannung oder alternativ auch als gepulste Gleichspannung bereitgestellt werden. Wird die Brennspannung als gepulste Spannung ausgebildet, so sollten die AusSchaltzeiten der gepulsten Gleichspannung nicht mehr als 5 % betragen. Wahlweise kann die Stromversorgungseinrichtung noch ein weiteres Bauteil umfassen, mit welchem der Bogenentladungsstrom regelbar ist.

Bisher wurde beschrieben, dass erfindungsgemäße Verfahren und Vorrichtungen zum Zünden einer Hohlkathoden-Bogenentladung geeignet sind. Mit erfindungsgemäßen Verfahren und Vorrichtungen kann eine Hohlkathoden-Bogenentladung jedoch auch aufrechterhalten werden bzw. kann damit sichergestellt werden, dass die Hohlkathoden-Bogenentladung nicht unabsichtlich erlischt. Droht das Erlöschen einer Bogenentladung, was beispielsweise in einem steilen Absinken des Bogenentladungsstromes zu erkennen ist, braucht lediglich mindestens ein Spannungspuls mit den gleichen Parametern wie beim Zünden der Hohlkathoden-Bogenentladung zwischen Hohlkathode und Anode erzeugt werden, um das Erlöschen der Hohlkathoden-Bogenentladung zu verhindern. Hierzu kann beispielsweise mittels einer Messeinrichtung der Bogenstrom erfasst und mittels einer Auswerteeinrichtung dann, wenn der erfasste Bogenstrom einen Bogenstrom-Sollwert unterschreitet, ein Signal generiert werden, infolge dessen das Erzeugen mindestens eines Spannungspulses von mindestens 500 V zwischen Hohlkathode und Anode ausgelöst wird. Andere Parameter, wie zum Beispiel die Magnetfeldstärke oder der Arbeitsgasdruck im Kathodenrohr, brauchen dann gegenüber ihren Werten beim ungestörten Aufrechterhalten der Bogenentladung nicht verändert zu werden.

Beim erstmaligen Zünden einer Hohlkathoden-Bogenentladung mit einer kalten Hohlkathode hingegen, bei dem es ja zunächst einmal darauf ankommt, möglichst viele Arbeitsgaspartikel zu ionisieren, kann es vorteilhaft sein, den Arbeitsgasdruck im Kathodenrohr bzw. die Arbeitsgasdurchflussmenge durch die Hohlkathode höher einzustellen als es dann beim betriebsgemäßen Aufrechterhalten der Hohlkathoden-Bogenentladung erforderlich ist. Bei einer Ausführungsform wird daher beim Zünden einer Hohlkathoden-Bogenentladung mindestens ein 5-fach höherer Arbeitsgasdruck im Kathodenrohr als beim Aufrechterhalten der Bogenentladung eingestellt. Als Arbeitsgas für erfindungsgemäße Verfahren und Vorrichtungen sind alle Arbeitsgase geeignet, die auch beim Beitreiben einer Hohlkathoden-Bogenentladung nach dem Stand der Technik verwendet werden, wie beispielsweise Edelgase und insbesondere Argon.

Aufgrund der Möglichkeit, das unabsichtliche Verlöschen einer Hohlkathoden-Bogenentladung zu unterbinden, sind erfindungsgemäße Verfahren und Vorrichtungen auch für den Einsatz bei mit dem Kürzel HAD⁺ bezeichneten Prozessen geeignet, bei denen der Arbeitsgasdruck nach dem Zünden einer Hohlkathoden-Bogenentladung bis auf einen Bereich abgesenkt wird, in dem eine Hohlkathoden-Bogenentladung mit Mitteln aus dem Stand der Technik nicht mehr stabil aufrechterhalten werden kann. Bei einer Ausführungsform wird daher die Durchflussmenge eines Arbeitsgases durch eine Hohlkathode nach dem Zünden einer Hohlkathoden-Bogenentladung auf unter 50 sccm und bei einer weiteren Ausführungsform auf unter 30 sccm abgesenkt.

Zusammenfassend kann festgehalten werden, dass erfindungsgemäße Verfahren und Vorrichtungen eine Vielzahl von Vorteilen gegenüber dem Stand der Technik aufweisen. So benötigt eine erfindungsgemäße Vorrichtung nur eine Stromversorgungseinrichtung, mittels der eine Hohlkathoden-Bogenentladung sowohl gezündet als auch aufrechterhalten werden kann. Es sind somit auch nur zwei elektrische Verbindungsleitungen, eine von der Hohlkathode und die andere von der zugehörigen Anode, zur Stromversorgungseinrichtung hin erforderlich. Gegenüber dem Stand der Technik entfallen daher beispielsweise die elektrischen Verbindungsleitungen zur Heizwendel oder anderen Hilfselektroden. Beim Einsatz einer Heizwendel oder von Hilfselektroden im Stand der Technik sind außerdem auch noch zusätzliche Stromversorgungseinrichtungen erforderlich. Des Weiteren lassen sich mit erfindungsgemäßen Verfahren und Vorrichtungen auch Hohlkathoden-Bogenentladungen bei sogenannten HAD⁺-Prozessen sicher zünden und stabil aufrechterhalten. Dabei werden für das Zünden einer Hohlkathoden-Bogenentladung nur einige Millisekunden benötigt, während beim Verwenden einer Heizwendel mindestens mehrere Minuten bis zum Zünden erforderlich sind.

### Ausführungsbeispiel

Die Erfindung wird nachfolgend anhand eines bevorzugten Ausführungsbeispiels näher erläutert. Die Fig. zeigen:
- Fig. 1: eine schematische Darstellung einer erfindungsgemäßen Vorrichtung;
- Fig. 2: ein Übersichtsschaltbild einer Stromversorgungseinrichtung;
- Fig. 3, 4: eine graphische Darstellung der Betriebspannung bzw. des Entladungsstroms einer Hohlkathoden-Bogenentladung während eines Zündvorgangs, aufgetragen über die Zeit;
- Fig. 5, 6: eine graphische Darstellung der Betriebspannung bzw. des Entladungsstroms einer Hohlkathoden-Bogenentladung während des betriebsgemäßen Aufrechterhaltens der Bogenentladung, aufgetragen über die Zeit.

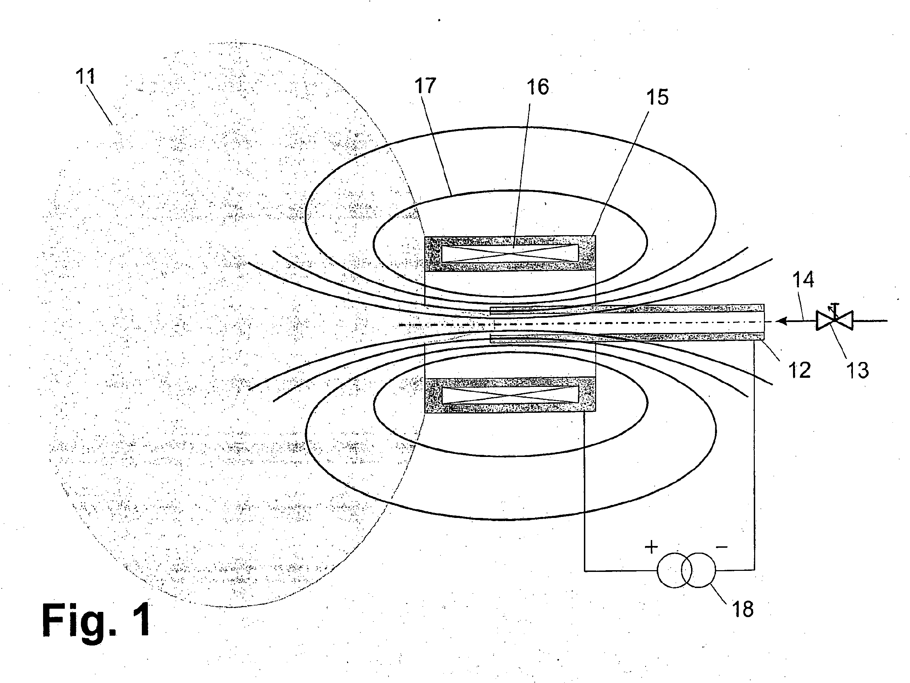

In Fig. 1 ist eine Vorrichtung zum Erzeugen eines Plasmas 11 schematisch dargestellt. Durch eine Hohlkathode 12 wird ein mittels eines Ventils 13 einstellbarer Gasfluss 14 des Arbeitsgases Argon in eine nicht dargestellte Vakuumkammer geführt. Der vordere Teil von Hohlkatode 12 ist von einer Anode 15 in Form eines Hohlzylinders umgeben. Dabei ist die Anode 15 rotationssymmetrisch um die Rohrachse von Hohlkathode 12 angeordnet. Im Inneren der Anode 15 befindet sich eine Drahtspule 16. Von einem elektrischen Strom der Stärke 20 A durchflossen, dient Drahtspule 16 zum Erzeugen eines Magnetfeldes 17 von 15 kA/m, welches sowohl die Hohlkatode 12 als auch den die Hohlkathode 12 umgebenden Raum durchdringt. Dabei weist das Magnetfeld 17 im vorderen Bereich der Hohlkathode 12, in welchem Elektronen die Hohlkathode 12 verlassen, Magnetfeldlinienbereiche auf, die parallel oder zumindest im Wesentlichen parallel zur Rohrachse der Hohlkathode 12 verlaufen, wobei Magnetfeldlinien mit gleicher Magnetfeldstärke rotationssymmetrisch um diese Achse angeordnet sind. Eine Stromversorgungseinrichtung 18 zum Bereitstellen der elektrischen Spannung für das Zünden und Aufrechterhalten einer Hohlkathoden-Bogenentladung ist einerseits mit Hohlkathode 12 und andererseits mit Anode 15 elektrisch verbunden.

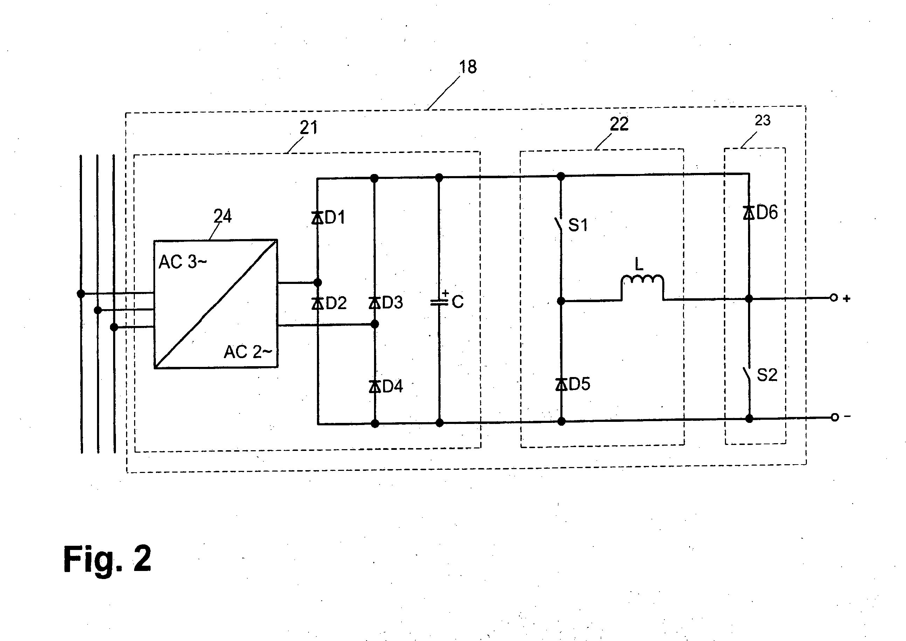

Ein Übersichtsschaltbild von Stromversorgungseinrichtung 18 ist in Fig. 2 dargestellt. Stromversorgungseinrichtung 18 besteht im Wesentlichen aus drei Bauteilen, einem Bauteil 21 für das Bereitstellen einer DC-Konstantspannung von maximal 1400 V, einem Bauteil 22 für das Regeln bzw. Begrenzen des Entladungsstromes der Hohlkathoden-Bogenentladung zwischen Hohlkathode 12 und Anode 15 sowie einem Bauteil 23, mit welchem je nach Anforderung entweder die Betriebsspannung für die Hohlkathoden-Bogenentladung oder Spannungspulse von mindestens 500 V für das Zünden der Hohlkathoden-Bogenentladung bzw. dafür, dass die Hohlkathoden-Bogenentladung nicht unabsichtlich erlischt, bereitgestellt werden.

Bauteil 21 umfasst einen Wandler 24, mit welchem zunächst eine dreiphasige Netzspannung mit einer Frequenz von 50 Hz in eine potentialfreie zweiphasige Spannung mit einer Frequenz von mehreren kHz gewandelt wird. Am Ausgang von Wandler 24 bilden Dioden D1 bis D4 eine bekannte Gleichrichterschaltung, so dass über der Kapazität C eine konstante Gleichspannung von maximal 1400 V abfällt.

Ein Schalter S1, eine Induktivität L und eine als Freilaufdiode für die Induktivität L fungierende Diode D5 sind Bestandteile des Bauteils 22. Mit nicht dargestellten Messmitteln wird der durch die Induktivität L fließende elektrische Strom erfasst und wenn dieser einen vorgegebenen Strom-Sollwert erreicht, wird Schalter S1 geöffnet. S1 wird wieder geschlossen, wenn der Strom einen eingestellten Hysterese-Wert unterschreitet. Auf diese Weise kann der Entladungsstrom der Hohlkathoden-Bogenentladung geregelt bzw. auf einen vorgegebenen Maximalwert begrenzt werden, denn der durch die Induktivität L fließende elektrische Strom ist gleichbedeutend mit dem Entladungsstrom der Hohlkathoden-Bogenentladung.

Das Bauteil 23 umfasst einen Schalter S2 und eine Diode D6. Wenn der Schalter S2 geschlossen und somit der Ausgang der Stromversorgungseinrichtung 18 kurzgeschlossen ist, wird die Induktivität L aufgeladen und somit elektrische Energie in der Induktivität L gespeichert. Beim Öffnen des Schalters S2 erzeugt dann die Induktivität L eine Selbstinduktionsspannung, die über dem mit "-" und "+" gekennzeichneten Ausgang der Stromversorgungseinrichtung 18 und somit zwischen Hohlkathode 12 und Anode 15 anliegt. Die Selbstinduktionsspannung bewirkt wiederum, dass ein elektrischer Strom in die Bogenentladung getrieben wird. Beim Öffnen des Schalters S2 wird daher ein Spannungspuls zwischen Hohlkathode 12 und Anode 15 erzeugt. Je länger der Schalter S2 geschlossen ist, umso mehr Energie wird in der Induktivität L gespeichert, umso höher wird die Selbstinduktionsspannung mit dem Öffnen des Schalters S2 und umso höher wird folglich auch der Spannungspuls am Ausgang der Stromversorgung 18. Steigt die Selbstinduktionsspannung über der Induktivität L so weit an, dass die Spannung am Ausgang der Stromversorgungseinrichtung, also über dem geöffneten Schalter S2, größer wird als die über die Kapazität C abfallende Spannung, wird Diode D6 leitend, wodurch die Höhe der Spannungspulse am Ausgang der Stromversorgungseinrichtung 18 auf die über die Kapazität C abfallende Spannung begrenzt wird.

Ein Spannungspuls am Ausgang der Stromversorgungseinrichtung 18 wird jedoch nicht nur mit dem Öffnen des Schalters S2 erzeugt, sondern auch beim Abreißen des Entladungsstromes der Hohlkathoden-Bogenentladung. Denn beim Abreißen des Entladungsstromes, der ja auch durch die Induktivität L fließt, wird wiederum eine über der Induktivität L abfallende Selbstinduktionsspannung erzeugt, welche den Strom durch die Induktivität L weiter treibt. Droht also das Verlöschen der Hohlkathoden-Bogenentladung zwischen Hohlkathode 12 und Anode 15, was einen Abriss bzw. ein abruptes Absinken des Entladungsstromes zur Folge hat, wird aufgrund der Schaltungskonfiguration der Stromversorgungseinrichtung 18 am Ausgang der Stromversorgungseinrichtung 18 automatisch ein Spannungspuls von mindestens 500 V generiert, der den Entladungsstrom weitertreibt und somit das Erlöschen der Hohlkathoden-Bogenentladung verhindert. Solch ein Spannungspuls zum Aufrechterhalten der Hohlkathoden-Bogenentladung könnte auch steuerungstechnisch generiert werden, indem beispielsweise der Entladungsstrom überwacht und beim Unterschreiten eines Stromsollwertes ein solcher Spannungspuls generiert wird.

Aufgrund der besonderen Schaltungskonfiguration von Stromversorgungseinrichtung 18 ist ein solcher Regelkreis nicht erforderlich, sondern Stromversorgungseinrichtung 18 stellt während des Betriebes einer Hohlkathoden-Bogenentladung die dafür erforderliche Brennspannung (auch Betriebsspannung genannt) zur Verfügung und generiert dann, wenn der Strom absinkt, automatisch einen Spannungspuls, der die Bogenentladung am Erlöschen hindert.

Stromversorgungseinrichtung 18 ist als sogenannte unipolar gepulste Stromversorgungseinrichtung ausgebildet, was bedeutet, dass eine gepulste Gleichspannung als Betriebsspannung für die Hohlkathoden-Bogenentladung bereitgestellt wird. Dabei erfolgt das Pulsen der Gleichspannung durch das periodische Schließen und Öffnen des Schalters S2.

Bei einem ersten Ausführungsbeispiel wird die Vorrichtung aus Fig. 1 zum Erzeugen eines Plasmas verwendet, welches zur Plasmavorbehandlung (auch Ionenätzen genannt) von Werkzeugen vor einer Beschichtung der Werkzeuge verwendet werden soll. Während des Zündvorgangs werden 100 sccm Argon durch die Hohlkathode 12 in die Vakuumkammer gelassen, in welcher ein Kammerdruck von 1x10⁻³ mbar aufrechterhalten wird. Bei allen nachfolgend beschriebenen Handlungen bzw. Vorgängen fließt durch die Spule 16 ein Strom von 20 A, welcher bei der gegebenen Spulenkonfiguration ein Magnetfeld von 15 kA/m bewirkt.

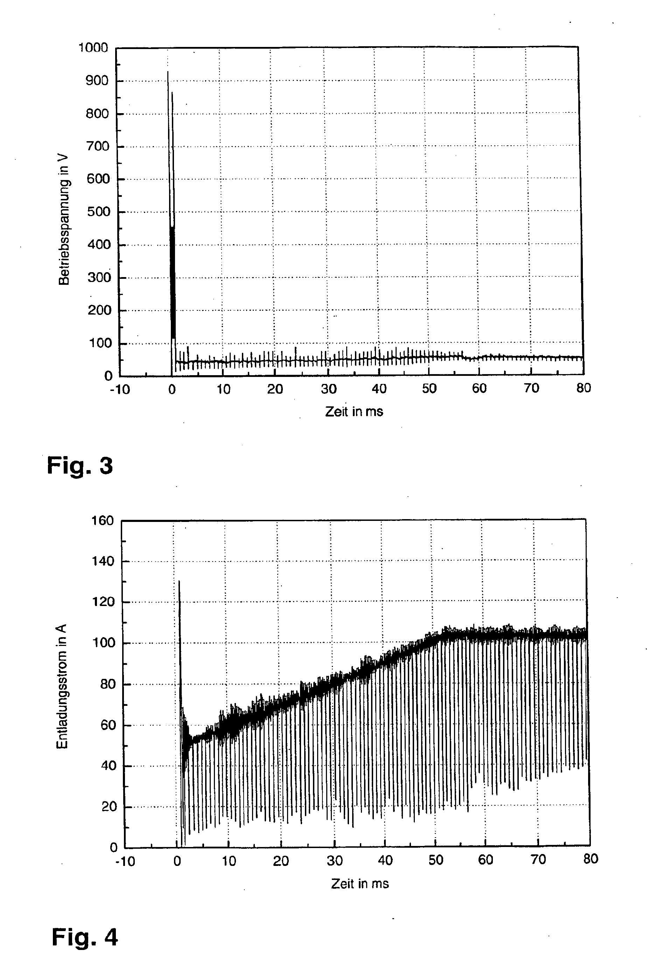

Die Stromversorgungseinrichtung 18 wird unipolar gepulst betrieben, indem Schalter S2 periodisch für 800 µs geöffnet und für 20 µs geschlossen wird. Mittels des Bauteils 22 der Stromversorgungseinrichtung 18 wird der Bogenentladungsstrom auf etwa 100 A begrenzt. In den Fig. 3 und 4 sind die Betriebspannung (also die Spannung zwischen Kathode 12 und Anode 15) bzw. der Entladungsstrom der Hohlkathoden-Bogenentladung während des Zündvorgangs graphisch dargestellt.

Zum Zeitpunkt "0" wird der Schalter S2 von Stromversorgungseinrichtung 18 das erste Mal geöffnet. Die Induktivität L war zuvor mit elektrischer Energie aufgeladen und die Hohlkathode 12 vollständig auf Umgebungstemperatur abgekühlt. Dadurch, dass zum Zeitpunkt "0" noch kein Strom in die Bogenentladung fließt, wird mit dem Öffnen des Schalters S2 ein Spannungspuls von etwa 900 V am Ausgang der Stromversorgungseinrichtung 18 und somit zwischen Hohlkathode 12 und Anode 15 erzeugt. Wie aus Fig. 4 ersichtlich ist, konnte dieser erste Spannungspuls noch keinen messbaren Stromfluss zwischen Hohlkathode 12 und Anode 15 bewirken. Nach 800 µs wird Schalter S2 geschlossen, infolgedessen Induktivität L erneut mit elektrischer Energie aufgeladen wird. Nach weiteren 20 µs öffnet Schalter S2 erneut, wodurch ein zweiter Spannungspuls von etwa 900 V zwischen Hohlkathode 12 und Anode 15 erzeugt wird. Infolge des zweiten Spannungspulses wurden nun so viele Elektronen aus Hohlkathode 12 emittiert und so viele Argonpartikel ionisiert, dass zunächst ein Strompuls von etwa 130 A und im Anschluss daran ein kurzes Einpegeln des Stromflusses bei etwa 50 A zu verzeichnen ist. Die Bogenentladung ist erfolgreich gezündet, was durch den nun kontinuierlich steigenden Entladungsstrom erkennbar ist, bis nach etwa 50 ms der eingestellte maximale Entladungsstrom von etwa 100 A erreicht ist und die Hohlkathoden-Bogenentladung stabil brennt.

Nach dem erfolgreichen Zünden der Hohlkathoden-Bogenentladung mit dem zweiten Spannungspuls von etwa 900 V erfolgt weiterhin das periodische Schließen und Öffnen des Schalters S2, nur bewirkt das nun folgende periodische Öffnen des Schalters S2 keine so hohen Spannungspulse wie vor dem Zünden der Bogenentladung, weil die gezündete Bogenentladung nur eine geringe Impedanz aufweist. Dennoch werden mit jedem Öffnen des Schalters S2 in Fig. 3 erkennbare kleine Spannungsspitzen erzeugt, die jedoch weder auf die stabil brennende Bogenentladung noch auf das erzeugte Plasma 11 negative Auswirkungen haben. Im zeitlichen Verlauf des Entladungsstromes in Fig. 4 sind ebenfalls die Schalthandlungen des Schalters S2 als periodische Stromeinbrüche zu erkennen, welche aber ebenfalls keine negativen Auswirkungen auf die Bogenentladung und das erzeugte Plasma haben.

Der Vollständigkeit halber sei an dieser Stelle noch einmal explizit erwähnt, dass das Pulsen der Betriebsspannung, welche sich nach dem Zünden der Hohlkathoden-Bogenentladung im eben beschriebenen Ausführungsbeispiel bei etwa 50 V einstellt, kein zwingendes Merkmal für erfindungsgemäße Verfahren und Vorrichtungen darstellt, sondern erfindungsgemäß ist es nur erforderlich, dass bis zum Zünden der Bogenentladung Spannungspulse von mindestens 500 V erzeugt werden. Die Brennspannung während des betriebsgemäßen Aufrechterhaltens einer Bogenentladung nach deren Zündung kann auch als ungepulste Gleichspannung bereitgestellt werden.

Gemäß dem ersten Ausführungsbeispiel werden nach dem Zünden der Hohlkathoden-Bogenentladung und für das einsatzgemäße Betreiben der Hohlkathoden-Bogenentladung einige Prozessparameter verändert. So wird beispielsweise mittels einer in Fig. 1 nicht dargestellten Zuführungsleitung ein zusätzlicher Gasfluss von 200 sccm in die Vakuumkammer eingelassen und dadurch ein Kammerdruck von 3x10⁻³ mbar erzeugt. Des Weiteren wird der Entladungsstrom auf 50 A begrenzt und die periodischen Schließzeiten des Schalters S2 auf 10 µs verkürzt. Durch das Verkürzen der Schließzeiten von Schalter S2 lassen sich beispielsweise die kleinen Spannungsspitzen, die durch das Öffnen des Schalters S2 hervorgerufen werden, noch weiter minimieren.

Bei einem zweiten Ausführungsbeispiel wird mit der Vorrichtung aus Fig. 1 ein Plasma erzeugt, mit welchem eine Plasmaaktivierung bei einer Schüttgutbedampfung durchgeführt werden soll. Während des Zündvorgangs werden wiederum 100 sccm Argon durch die Hohlkathode 12 in die Vakuumkammer gelassen, in welcher ein Kammerdruck von 2x10⁻³ mbar aufrechterhalten wird. Die Stromversorgungseinrichtung 18 wird abermals unipolar gepulst betrieben, indem Schalter S2 periodisch für 800 µs geöffnet, aber diesmal für 40 µs geschlossen wird. Mittels des Bauteils 22 der Stromversorgungseinrichtung 18 wird der Bogenentladungsstrom auf etwa 100 A begrenzt.

Durch das Verlängern der periodischen Schließzeiten von Schalter S2 kann die Induktivität bei geschlossenem Schalter S2 auch länger mit Energie aufgeladen werden, wodurch beim Öffnen des Schalters S2 Spannungspulse von 1400 V zwischen Hohlkathode 12 und Anode 15 generiert werden, bis eine Hohlkathoden-Bogenentladung nach wenigen dieser Spannungspulse gezündet ist. Danach brennt die Bogenentladung mit einer gepulsten Betriebspannung von etwa 50 V. Nachdem die Bogenentladung stabil brennt, werden einige Betriebsparameter an der Vorrichtung neu eingestellt. Hierzu werden die Schließzeiten des Schalters S2 wiederum auf 10 µs verkürzt, der Sollstrom für die Bogenentladung auf 160 A erhöht, ein zusätzlicher Gasfluss von 80 sccm in die Vakuumkammer geleitet, der Argonfluss durch die Holkathode 12 auf 20 sccm reduziert, wodurch der Kammerdruck von 2x10⁻³ mbar aufrechterhalten bleibt. Bei diesen Parametern stellt sich eine Brennspannung von etwa 100 V zwischen Hohlkathode 12 und Anode 15 ein.

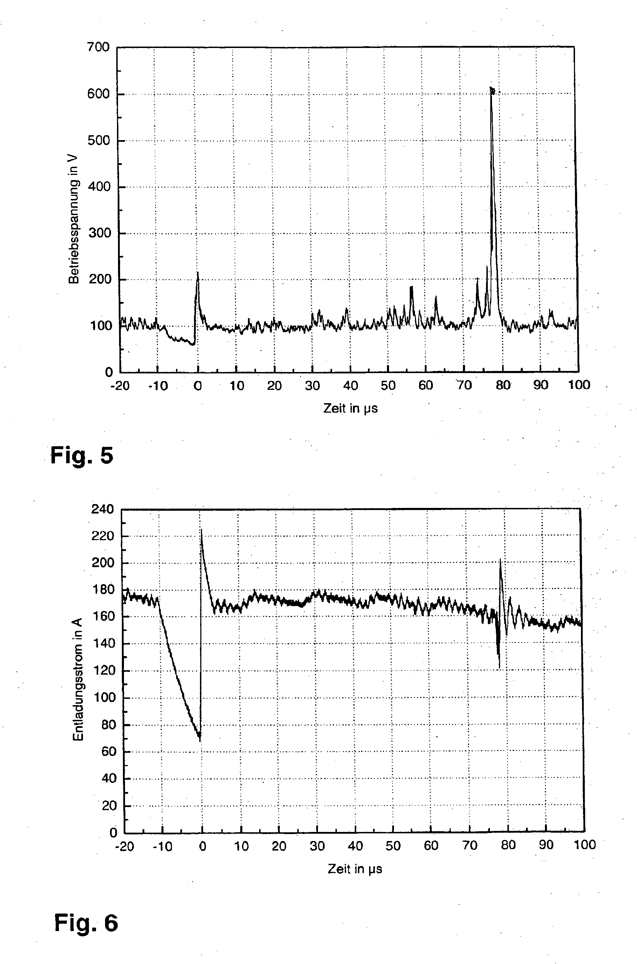

Ein zeitlicher Verlauf der Betriebsspannung und des Entladungsstromes bei diesen Prozessparametern sind in Fig. 5 bzw. Fig. 6 graphisch dargestellt. Der Zeitraum von -10 µs bis 0 µs stellt eine Zeitspanne des gewollten periodischen Pulsens der Brennspannung dar, in welcher der Schalter S2 geschlossen ist. Bei geschlossenem Schalter S2 sinkt der Entladungsstrom für 10 µs mit einer Flanke bis auf etwa 70 A ab, ein kontinuierlicher, wenn auch sinkender Stromfluss bleibt aber immer erhalten. Nach dem Öffnen des Schalters S2 zum Zeitpunkt "0" wird eine kleine Spannungsspitze generiert, die wiederum eine Stromspitze zur Folge hat, bis beide Parameter wieder auf den Betriebszustand einschwingen.

Das Absenken des Argonflusses durch Hohlkathode 12 auf 20 sccm führt einerseits zu einem sehr intensiv leuchtenden Plasma mit einer sehr hohen Plasmadichte, andererseits aber auch zu einem Gasdruck im Kathodenrohr, bei dem die Hohlkathoden-Bogenentladung nicht mehr sicher aufrechterhalten werden kann. Kurz vor dem Zeitpunkt bei 80 µs in Fig. 5 und 6 ist solch ein Moment erfasst, bei dem der Entladungsstrom mit sehr steiler Flanke unter die üblichen Stromschwankungen während des Betriebes absinkt und die Bogenentladung zu verlöschen droht. Stromversorgung 18 generiert daraufhin einen Spannungspuls von etwa 600 V, der einen Anstieg des Stromflusses zur Folge hat, wodurch die Hohlkathoden-Bogenentladung am Brennen bleibt.

Im Stromverlauf von Fig. 6 ist auch das Wirken des Stromregelbauteils 22 von Stromversorgungseinrichtung 18 zu erkennen. Beispielsweise in den Zeitbereichen 10 bis 28 µs, 28 bis 44 µs und 44 bis 60 µs vollführt der Verlauf des Entladungsstromes jeweils zunächst eine Aufwärtsbewegung und anschließend eine Abwärtsbewegung, wobei die Phasen einer Aufwärtsbewegung dann stattfinden, wenn Schalter S1 geschlossen ist, der bei Erreichen des eingestellten Maximalwertes des Entladungsstroms geöffnet wird, was dann die Phasen des abfallenden Stromverlaufs bewirkt, bis der Schalter S1 abermals geschlossen wird, worauf der Entladungsstrom erneut ansteigt.

## Patentansprüche

1. Verfahren zum Betreiben einer Bogenentladung zwischen einer Anode (15) und einer rohrförmigen Kathode (12), durch die ein Arbeitsgas in eine Vakuumkammer geleitet wird, wobei zumindest ausgangsseitig um die Kathode (12) ein Magnetfeld (17) erzeugt wird, welches Feldlinienbereiche aufweist, die parallel zur Rohrachse der Kathode (12) verlaufen und wobei mittels einer Stromversorgungseinrichtung (18) eine elektrische Spannung zwischen Kathode (12) und Anode (15) erzeugt wird, **dadurch gekennzeichnet, dass** mittels der Stromversorgungseinrichtung (18) sowohl die Brennspannung für die Bogenentladung als auch mindestens ein Spannungspuls von mindestens 500 V zum Zünden oder Aufrechterhalten der Bogenentladung erzeugt werden, indem die Stromversorgungseinrichtung (18) derart ausgebildet wird, dass diese ein Bauteil (21) umfasst, mit welchem eine maximale Konstantspannung von mindestens 500 V bereitgestellt wird; ein Bauteil (22), mit welchem der Bogenentladungsstrom geregelt wird und ein Bauteil (23), mit welchem einerseits die Brennspannung für die Kathoden-Bogenentladung und andererseits Spannungspulse von mindestens 500 V erzeugt werden.

2. Verfahren nach Anspruch 1, **dadurch gekennzeichnet, dass** das Magnetfeld (17) mit einer Stärke von mindestens 1 kA/m erzeugt wird.

3. Verfahren nach Anspruch 1 oder 2, **dadurch gekennzeichnet, dass** Spannungspulse mit einer Dauer von 0,5 µs bis 50 µs erzeugt werden.

4. Verfahren nach einem der vorhergehenden Ansprüche, **dadurch gekennzeichnet, dass** Spannungspulse mit einer Wiederholfrequenz von 10 Hz bis 10 kHz erzeugt werden.

5. Verfahren nach einem der Ansprüche 1 bis 4, **dadurch gekennzeichnet, dass** beim Zünden der Bogenentladung ein Druck des Arbeitsgases innerhalb des Kathodenrohres eingestellt wird, der mindestens 5-fach höher ist als beim Aufrechterhalten der Bogenentladung.

6. Verfahren nach einem der Ansprüche 1 bis 4, **dadurch gekennzeichnet, dass** beim Aufrechterhalten der Bogenentladung die Durchflussmenge des Arbeitsgases durch die Kathode (12) auf einen Bereich abgesenkt wird, in welchem ein stabiler Betrieb der Bogenentladung nicht mehr möglich ist.

7. Verfahren nach Anspruch 6, **dadurch gekennzeichnet, dass** die Durchflussmenge des Arbeitsgases durch die Kathode (12) auf unter 50 sccm abgesenkt wird.

8. Verfahren nach einem der vorhergehenden Ansprüche, **dadurch gekennzeichnet, dass** der Bogenentladungsstrom mittels einer Messeinrichtung erfasst wird und dass beim Unterschreiten eines Bogenentladungsstrom-Sollwertes mindestens ein Spannungspuls zwischen Kathode (12) und Anode (15) erzeugt wird.

9. Vorrichtung zum Betreiben einer Bogenentladung, umfassend eine rohrförmige Kathode (12), durch die ein Arbeitsgas in eine Vakuumkammer leitbar ist, eine Einrichtung (16) zum Erzeugen eines Magnetfeldes (17), welches zumindest die Ausgangsseite der rohrförmigen Kathode (12) durchdringt und welches Feldlinien aufweist, die zumindest in einem Bereich parallel zur Rohrachse der Kathode (12) verlaufen, sowie eine Stromversorgungseinrichtung (18) zum Erzeugen einer Spannung zwischen Kathode (12) und Anode (15), **dadurch gekennzeichnet, dass** mittels der Stromversorgungseinrichtung (18) einerseits die Brennspannung für die Bogenentladung und andererseits mindestens ein Spannungspuls von mindestens 500 V zum Zünden und Aufrechterhalten der Bogenentladung erzeugbar sind, wobei die Stromversorgungseinrichtung (18) umfasst: ein Bauteil (21), mit welchem eine maximale Konstantspannung von mindestens 500 V bereitstellbar ist; ein Bauteil (22), mit welchem der Bogenentladungsstrom regelbar ist und ein Bauteil (23), mit welchem einerseits die Brennspannung für die Kathoden-Bogenentladung und andererseits Spannungspulse von mindestens 500 V erzeugbar sind.

10. Vorrichtung nach Anspruch 9, **dadurch gekennzeichnet, dass** mittels des Bauteils (23) Spannungspulse mit einer Dauer von 0,5 µs bis 50 µs erzeugbar sind.

11. Vorrichtung nach Anspruch 9 oder 10, **dadurch gekennzeichnet, dass** mittels des Bauteils (23) Spannungspulse mit einer Wiederholfrequenz von 10 Hz bis 10 kHz erzeugbar sind.

12. Vorrichtung nach einem der vorhergehenden Ansprüche, **gekennzeichnet durch** eine Messeinrichtung, mittels der der Bogenentladungsstrom erfassbar ist.

13. Vorrichtung nach Anspruch 12, **dadurch gekennzeichnet, dass** mittels einer Auswerteeinrichtung dann, wenn der erfasste Bogenentladungsstrom einen Bogenentladungsstrom-Sollwert unterschreitet, ein Signal generierbar ist, welches das Erzeugen mindestens eines Spannungspulses zwischen Kathode (12) und Anode (15) auslöst.

14. Vorrichtung nach einem der Ansprüche 9 bis 13, **dadurch gekennzeichnet, dass** die Vorrichtung (16) zum Erzeugen des Magnetfeldes (17) als stromdurchflossene Spule ausgebildet ist.

15. Vorrichtung nach einem der Ansprüche 9 bis 13, **dadurch gekennzeichnet, dass** die Vorrichtung zum Erzeugen des Magnetfeldes als Anordnung von Permanentmagneten ausgebildet ist.

16. Vorrichtung nach einem der vorhergehenden Ansprüche, **dadurch gekennzeichnet, dass** die Stromversorgungseinrichtung (18) ein erstes Bauteil (21) zum Erzeugen einer konstanten Gleichspannung von mindestens 500 V, ein zweites Bauteil (22) zum Regeln des ausgangsseitigen elektrischen Stromes und ein drittes Bauteil (23), mit welchem einerseits die Brennspannung für die Bogenentladung und andererseits mindestens ein Spannungspuls von mindestens 500 V generierbar ist, umfaßt.

## Claims

1. Method for operating an arc discharge between an anode (15) and a tubular cathode (12), through which a working gas is conducted into a vacuum chamber, a magnetic field (17) being generated around the cathode (12), at least on the output side, and having regions of the lines of flux that run parallel to the tube axis of the cathode (12), and an electrical voltage being generated between the cathode (12) and the anode (15) by means of a power supply device (18), **characterized in that** both the burning voltage for the arc discharge and at least one voltage pulse of at least 500 V is generated by means of the power supply device (18) for igniting or maintaining the arc discharge, **in that** the power supply device (18) is designed in such a way that it comprises a component (21), with which a maximum constant voltage of at least 500 V is provided, a component (22), with which the arc discharge current is controlled, and a component (23), with which on the one hand the burning voltage for the cathode arc discharge and on the other hand voltage pulses of at least 500 V are generated.

2. Method according to Claim 1, **characterized in that** the magnetic field (17) is generated with a strength of at least 1 kA/m.

3. Method according to Claim 1 or 2, **characterized in that** voltage pulses with a duration of 0.5 µs to 50 µs are generated.

4. Method according to one of the preceding claims, **characterized in that** voltage pulses with a repetition frequency of 10 Hz to 10 kHz are generated.

5. Method according to one of Claims 1 to 4, **characterized in that**, when igniting the arc discharge, a pressure of the working gas within the cathode tube is set to be at least five times higher than when the arc discharge is being maintained.

6. Method according to one of Claims 1 to 4, **characterized in that**, when maintaining the arc discharge, the flow rate of the working gas through the cathode (12) is lowered to a range in which stable operation of the arc discharge is no longer possible.

7. Method according to Claim 6, **characterized in that** the flow rate of the working gas through the cathode (12) is lowered to below 50 sccm.

8. Method according to one of the preceding claims, **characterized in that** the arc discharge current is sensed by means of a measuring device and **in that**, if it falls below an arc-discharge-current target value, at least one voltage pulse between the cathode (12) and the anode (15) is generated.

9. Device for operating an arc discharge, comprising a tubular cathode (12), through which a working gas can be conducted into a vacuum chamber, a device (16) for generating a magnetic field (17), which penetrates at least through the output side of the tubular cathode (12) and has lines of flux that at least in one region run parallel to the tube axis of the cathode (12), and also a power supply device (18) for generating a voltage between the cathode (12) and the anode (15), **characterized in that** on the one hand the burning voltage for the arc discharge and on the other hand at least one voltage pulse of at least 500 V can be generated by means of the power supply device (18) for igniting and maintaining the arc discharge, the power supply device (18) comprising: a component (21), with which a maximum constant voltage of at least 500 V can be provided, a component (22), with which the arc discharge current can be controlled, and a component (23), with which on the one hand the burning voltage for the cathode arc discharge and on the other hand voltage pulses of at least 500 V can be generated.

10. Device according to Claim 9, **characterized in that** voltage pulses with a duration of 0.5 µs to 50 µs can be generated by means of the component (23).

11. Device according to Claim 9 or 10, **characterized in that** voltage pulses with a repetition frequency of 10 Hz to 10 kHz can be generated by means of the component (23).

12. Device according to one of the preceding claims, **characterized by** a measuring device, by means of which the arc discharge current can be sensed.

13. Device according to Claim 12, **characterized in that**, whenever the sensed arc discharge current falls below an arc-discharge-current target value, a signal that initiates the generation of at least one voltage pulse between the cathode (12) and the anode (15) can be generated by means of an evaluation device.

14. Device according to one of Claims 9 to 13, **characterized in that** the device (16) for generating the magnetic field (17) is designed as a coil through which current can flow.

15. Device according to one of Claims 9 to 13, **characterized in that** the device for generating the magnetic field is designed as an arrangement of permanent magnets.

16. Device according to one of the preceding claims, **characterized in that** the power supply device (18) comprises a first component (21), for generating a constant DC voltage of at least 500 V, a second component (22), for controlling the output-side electrical current, and a third component (23), with which on the one hand the burning voltage for the arc discharge and on the other hand at least one voltage pulse of at least 500 V can be generated.

## Revendications

1. Procédé pour opérer une décharge en arc entre une anode (15) et une cathode (12) tubulaire à travers laquelle un gaz de travail est acheminé dans une chambre sous vide, un champ magnétique (17) étant généré autour de la cathode (12) au moins du côté de la sortie, lequel présente des zones de ligne de champ qui s'étendent parallèlement à l'axe de tube de la cathode (12), et une tension électrique étant générée entre la cathode (12) et l'anode (15) au moyen d'un dispositif d'alimentation électrique (18), **caractérisé en ce que** la tension de fonctionnement pour la décharge en arc ainsi qu'au moins une impulsion de tension d'au moins 500 V destinée à amorcer ou à maintenir la décharge en arc sont générées au moyen du dispositif d'alimentation électrique (18) **en ce que** le dispositif d'alimentation électrique (18) est configuré de telle sorte que celui-ci inclut un composant (21) avec lequel est mise à disposition une tension constante maximale au moins égale à 500 V ; un composant (22) avec lequel le courant de décharge en arc est régulé et un composant (23) avec lequel sont générées d'une part la tension de fonctionnement pour la décharge en arc de la cathode et d'autre part des impulsions de tension d'au moins 500 V.

2. Procédé selon la revendication 1, **caractérisé en ce que** le champ magnétique (17) est généré avec une intensité minimale de 1 kA/m.

3. Procédé selon la revendication 1 ou 2, **caractérisé en ce que** des impulsions de tension ayant une durée de 0,5 µs à 50 µs sont générées.

4. Procédé selon l'une des revendications précédentes, **caractérisé en ce que** des impulsions de tension ayant une fréquence de répétition de 10 Hz à 10 kHz sont générées.

5. Procédé selon l'une des revendications 1 à 4, **caractérisé en ce que** lors de l'amorçage de la décharge en arc, une pression du gaz de travail est réglée à l'intérieur du tube de cathode, laquelle est au moins 5 fois supérieure à celle lors du maintien de la décharge en arc.

6. Procédé selon l'une des revendications 1 à 4, **caractérisé en ce que** lors du maintien de la décharge en arc, le débit volumique du gaz de travail à travers la cathode (12) est abaissé à une plage dans laquelle une opération stable de la décharge en arc n'est plus possible.

7. Procédé selon la revendication 6, **caractérisé en ce que** le débit volumique du gaz de travail à travers la cathode (12) est abaissé au-dessous de 50 Ncm³/min.

8. Procédé selon l'une des revendications précédentes, **caractérisé en ce que** le courant de décharge en arc est détecté au moyen d'un dispositif de mesure et **en ce qu'**au moins une impulsion de tension est générée entre la cathode (12) et l'anode (15) dans le cas où le courant de décharge en arc devient inférieur à une valeur de consigne de courant de décharge en arc.

9. Dispositif pour opérer une décharge en arc, comprenant une cathode (12) tubulaire à travers laquelle un gaz de travail peut être acheminé dans une chambre sous vide, un dispositif (16) servant à générer un champ magnétique (17), lequel traverse au moins le coté de la sortie de la cathode (12) tubulaire et lequel présente des lignes de champ qui, au moins dans une zone, s'étendent parallèlement à l'axe de tube de la cathode (12), ainsi qu'un dispositif d'alimentation électrique (18) destiné à générer une tension entre la cathode (12) et une anode (15), **caractérisé en ce que** la tension de fonctionnement pour la décharge en arc d'une part et au moins une impulsion de tension d'au moins 500 V destinée à amorcer et à maintenir la décharge en arc d'autre part peuvent être générées au moyen du dispositif d'alimentation électrique (18), le dispositif d'alimentation électrique (18) comprenant : un composant (21) avec lequel peut être mise à disposition une tension constante maximale au moins égale à 500 V ; un composant (22) avec lequel le courant de décharge en arc peut être régulé et un composant (23) avec lequel peuvent être générées d'une part la tension de fonctionnement pour la décharge en arc de la cathode et d'autre part des impulsions de tension d'au moins 500 V.

10. Dispositif selon la revendication 9, **caractérisé en ce que** des impulsions de tension ayant une durée de 0,5 µs à 50 µs peuvent être générées au moyen du composant (23).

11. Dispositif selon la revendication 9 ou 10, **caractérisé en ce que** des impulsions de tension ayant une fréquence de répétition de 10 Hz à 10 kHz peuvent être générées au moyen du composant (23).

12. Dispositif selon l'une des revendications précédentes, **caractérisé par** un dispositif de mesure à l'aide duquel peut être détecté le courant de décharge en arc.

13. Dispositif selon la revendication 12, **caractérisé en ce qu'**un signal peut être généré au moyen d'un dispositif d'interprétation lorsque le courant de décharge en arc détecté devient inférieur à une valeur de consigne de courant de décharge en arc, ledit signal déclenchant la génération d'au moins une impulsion de tension entre la cathode (12) et l'anode (15).

14. Dispositif selon l'une des revendications 9 à 13, **caractérisé en ce que** le dispositif (16) servant à générer le champ magnétique (17) est configuré sous la forme d'une bobine traversée par un courant.

15. Dispositif selon l'une des revendications 9 à 13, **caractérisé en ce que** le dispositif servant à générer le champ magnétique est configuré sous la forme d'un arrangement d'aimants permanents.

16. Dispositif selon l'une des revendications précédentes, **caractérisé en ce que** le dispositif d'alimentation électrique (18) comprend un premier composant (21) destiné à générer une tension continue constante au moins égale à 500 V, un deuxième composant (22) destiné à réguler le courant électrique du côté de la sortie et un troisième composant (23) avec lequel peuvent être générées d'une part la tension de fonctionnement pour la décharge en arc et d'autre part au moins une impulsion de tension d'au moins 500 V.
